# FASCICULE DE BREVET EUROPEEN

(11) **EP 0 755 175 B1**
(45) Date de publication et mention de la délivrance du brevet: **30.09.1998**
(21) Numéro de dépôt: 96401551.5
(22) Date de dépôt: 12.07.1996
(51) Int. Cl.: H05K 5/00, H02B 1/46

(54) **Dispositif de jumelage pour coffrets pour appareillages électriques**
Verbindungsvorrichtung für Gerätegehäuse
Connecting device for casings for electrical equipment

(30) Priorité: 18.07.1995 FR 9508662
(43) Date de publication de la demande: 22.01.1997
(73) Titulaire: LEGRAND, F-87000 Limoges (FR); LEGRAND SNC, F-87000 Limoges (FR)
(72) Inventeur: Tarrade, Gérard, 87000 Limoges (FR)
(74) Mandataire: CABINET BONNET-THIRION

(56) Documents cités:
- DE-B- 1 254 731
- DE-U- 9 104 063
- FR-A- 2 707 826
- GB-A- 2 233 505
- ELEKTROTECHNIK, vol. 69, no. 16, 14 Octobre 1987, WÜRZBURG, pages 60-62, XP000577389 "Keile statt Schrauben"

## Description

La présente invention concerne d'une manière générale les coffrets destinés au logement d'appareillage électriques.

Le plus souvent, ces coffrets sont formés, de manière distincte, d'une part, d'un fond, formant embase, sur lequel sont rapportés les appareillages électriques concernés, en pratique par l'intermédiaire d'un châssis, et, d'autre part, d'un habillage, communément appelé capot, auquel appartiennent les parois latérales de l'ensemble, et qui est rapporté sur le fond lorsque le câblage des appareillages électriques est terminé.

Cela est le cas, notamment, dans la demande de brevet français publiée sous le No 2 707 826, et cela est le cas, également, dans la demande de brevet britannique publiée sous le No 2 233 505.

La présente invention vise plus particulièrement, mais non nécessairement exclusivement, le cas où, pour satisfaire à des exigences particulières d'étanchéité, une partie au moins des parois latérales sont d'un seul tenant avec le fond, l'ensemble constituant un corps sur lequel est rapporté de manière étanche un capot se réduisant au reste de l'habillage.

Lorsque les circonstances l'exigent, et, par exemple, pour l'extension d'une installation déjà existante, il peut être nécessaire de disposer côte à côte deux de tels coffrets, suivant par exemple une rangée horizontale, avec, de l'un à l'autre, des câbles établissant une liaison électrique entre les appareillages électriques qu'ils renferment.

Cela suppose que l'une au moins de leurs parois latérales comporte au moins un ajour pour le passage de ces câbles, et, de fait, que ces parois latérales appartiennent en tout ou partie à un corps, ou qu'elles appartiennent en tout ou partie à un capot, des ajours plus ou moins étendus y sont usuellement prédécoupés.

Il importe, corollairement, de relier l'un à l'autre les deux coffrets par un dispositif de jumelage, ne fut-ce que pour établir entre eux une certaine continuité.

Dans la demande de brevet français No 93 07830 publiée sous le No 2 707 826, ce dispositif de jumelage est une entretoise, en forme générale d'anse, qui est rapportée sur l'un et l'autre des fonds des deux coffrets, et sur laquelle viennent s'emboîter, par une découpe ouverte de leur paroi latérale concernée, les capots de ces deux coffrets.

Outre qu'une telle disposition ne saurait convenir lorsque les parois latérales appartiennent au moins en partie à un corps comportant le fond, elle n'est pas en mesure d'apporter, au niveau des fonds, toute l'étanchéité qui peut être nécessaire.

Dans la demande de brevet britannique No 2 233 505, le dispositif de jumelage comporte, dans l'une de ses formes de réalisation, une paroi de pontage, qui, allongée en forme de tunnel, est apte à s'étendre de l'un à l'autre des deux coffrets, pour l'établissement d'une liaison entre les volumes internes de ceux-ci au niveau de leurs parois latérales.

Pour les mêmes raisons que précédemment, un tel dispositif de jumelage ne saurait convenir lorsque des exigences particulières sont à satisfaire en matière d'étanchéité.

Dans le document ELEKTROTECHNIK, vol. 69, No 16, du 14 octobre 1987, page 60-62, il est prévu une paroi de pontage qui, formant un tube, a une section transversale fermée en boucle sur elle-même, et qui, à ses extrémités, est équipée, sur sa tranche, de moyens d'étanchéité destinés à s'appliquer aux coffrets à relier.

Mais, cette paroi de pontage devant de ce fait être pincée entre les coffrets, sa mise en place est malaisée et sa tenue est incertaine.

En outre, sa mise en oeuvre rend plus complexe la réalisation des coffrets.

Il est prévu, par ailleurs, dans la demande de brevet allemand No 1 254 731, que les moyens d'étanchéité s'appliquent aux parois latérales de l'un et de l'autre des coffrets.

Cela étant, la présente invention a pour objet un dispositif de jumelage ne présentant pas les inconvénients précédents et conduisant en outre à d'autres avantages.

Ce dispositif de jumelage, qui est destiné à être établi entre deux coffrets disposés côte à côte, est du genre comportant une paroi de pontage, qui, allongée en forme de tunnel, est apte à s'étendre de l'un à l'autre des deux coffrets, pour l'établissement d'une liaison entre leurs volumes internes au niveau de leurs parois latérales, et qui, formant un tube, a une section transversale fermée en boucle sur elle-même, avec, entourant localement cette paroi de pontage, des moyens d'étanchéité aptes à s'appliquer aux parois latérales de l'un et de l'autre des coffrets, ce dispositif de jumelage étant d'une manière générale caractérisé en ce qu'il comporte un piétement, et en ce que ce piétement forme, du côté de chaque extrémité de la paroi de pontage, au moins une patte de liaison, qui, globalement allongée parallèlement à la paroi de pontage, à distance de celle-ci, est destinée à être insérée sous le fond du coffret correspondant.

Par exemple, suivant une forme particulière et préférée de réalisation, les moyens d'étanchéité ainsi mis en oeuvre comportent deux joints d'étanchéité adossés dos à dos à un flasque médian qui, présent en saillie transversalement sur la paroi de pontage, s'étend tout autour de cette paroi de pontage, dans la zone médiane de celle-ci.

Quoi qu'il en soit, grâce au contour fermé de la paroi de pontage et aux moyens d'étanchéité entourant celle-ci, une étanchéité satisfaisante peut en toute sécurité être obtenue.

En pratique, cette étanchéité peut être suffisante pour satisfaire aux conditions IP 55 des normes en la matière.

En outre, grâce aux pattes de liaison que forme son piétement, la mise en place du dispositif de jumelage suivant l'invention est avantageusement aisée.

En particulier, lorsque l'un des deux coffrets à relier est déjà installé et équipé, cette mise en place n'implique avantageusement pas le démontage complet de ce coffret.

Il suffit, au contraire, de desserrer légèrement ce coffret du côté où il doit être relié à un autre, pour l'écarter suffisamment de la surface de support sur laquelle il est rapporté pour que les pattes de liaison correspondantes puissent être insérées entre cette surface de support et lui.

Autrement dit, aucune intervention n'est avantageusement nécessaire sur la face arrière même d'un tel coffret déjà installé.

Enfin, grâce aux pattes de liaison du piétement, une liaison particulièrement fiable et sûre est établie entre chacun des coffrets et la paroi de pontage, au bénéfice d'un bon positionnement et d'une bonne tenue pour celle-ci.

Les caractéristiques et avantages de l'invention ressortiront d'ailleurs de la description qui va suivre, à titre d'exemple, en référence aux dessins schématiques annexés sur lesquels :
la figure 1 est une vue en perspective d'un coffret pour appareillages électriques auquel est plus particulièrement destiné le dispositif de jumelage suivant l'invention ;
la figure 2 est, à échelle supérieure, une vue en perspective de ce dispositif de jumelage, sans les moyens d'étanchéité associés à sa paroi de pontage ;
la figure 3 en est une vue en élévation de face, suivant la flèche III de la figure 2 ;
la figure 4 en est une vue en coupe transversale, suivant la ligne brisée IV-IV de la figure 3 ;
la figure 5 en est une vue de dessus, suivant la flèche V de la figure 3 ;
la figure 6 en est une vue de dessous, suivant la flèche VI de la figure 3 ;
la figure 7 en est, à échelle supérieure, une autre vue partielle en coupe transversale, suivant la ligne VII-VII de la figure 5 ;
la figure 8 est une vue en coupe transversale, qui, reprenant celle de la figure 4, illustre la mise en oeuvre du dispositif de jumelage suivant l'invention entre deux coffrets.

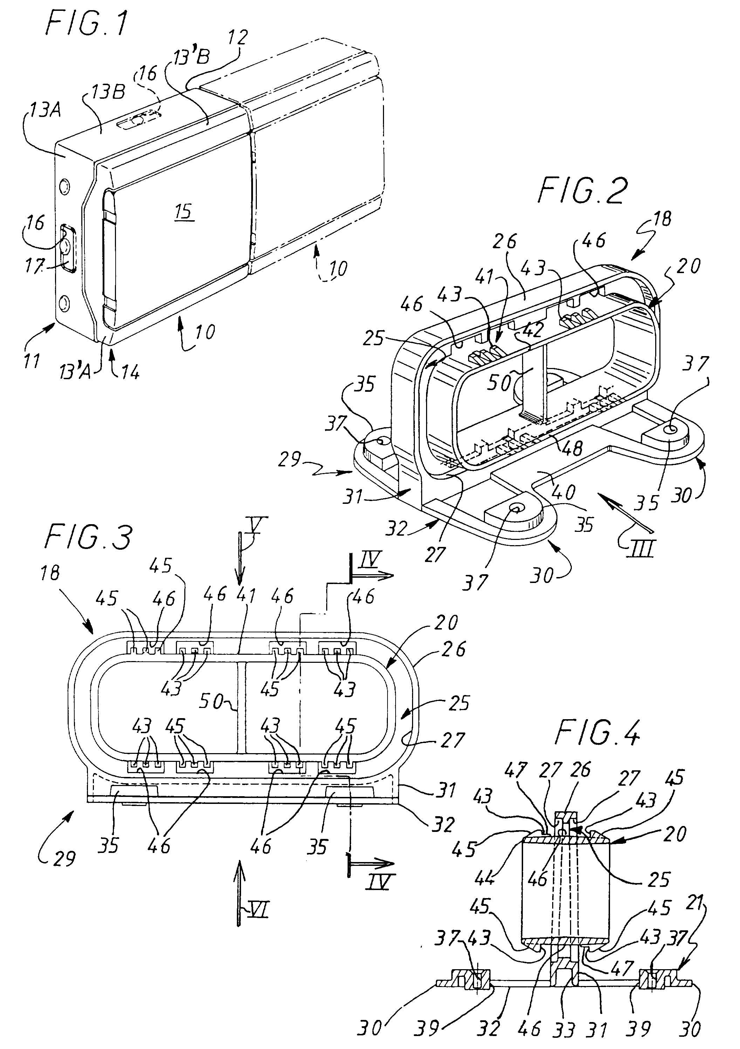

Tel qu'illustré, schématiquement, sur la figure 1, il s'agit, globalement, d'assurer une liaison, et, plus précisément, une liaison étanche, entre deux coffrets 10 disposés côte à côte, suivant, par exemple, et tel que représenté, un alignement horizontal.

Ces coffrets 10, qui sont en pratique identiques l'un à l'autre, et qui sont destinés l'un et l'autre au logement d'appareillages électriques de types divers, ne relèvent pas, par eux-mêmes, de la présente invention.

Ils ne seront donc pas décrits dans tous leurs détails ici.

Il suffira d'indiquer que, dans la forme de réalisation représentée, ils sont formés, d'une part, d'un corps 11, qui comporte, d'un seul tenant, un fond 12 et quatre parois latérales 13A, 13B, à savoir deux parois latérales 13A verticales, et, en alternance avec celles-ci, deux parois latérales 13B horizontales, et, d'autre part, d'un capot 14, qui est rapporté, de manière étanche, sur le corps 11, pour la fermeture de celui-ci.

Dans la forme de réalisation représentée, le capot 14 comporte, lui-même, des parois latérales 13'A, 13'B, qui viennent chacune respectivement dans le prolongement des parois latérales 13A, 13B du corps 11, pour le complètement de celles-ci, et il est équipé, en façade, d'une porte 15.

Chacune des parois latérales 13A verticales du corps 11 comporte, localement, au moins un ajour 16, qui, prédécoupé dans son épaisseur, est initialement obturé par un opercule défonçable 17.

Dans la forme de réalisation représentée, cet ajour 16 est allongé verticalement en rectangle, avec de larges arrondis dans ses angles.

Bien entendu, et tel que schématisé en traits interrompus sur la figure 1, chacune des parois latérales 13B horizontales peut également comporter un tel ajour 16 à opercule défonçable 17.

Lorsqu'une liaison doit être établie entre deux coffrets 10 dûment disposés côte à côte, il est préférentiellement mis en oeuvre un dispositif de jumelage 18.

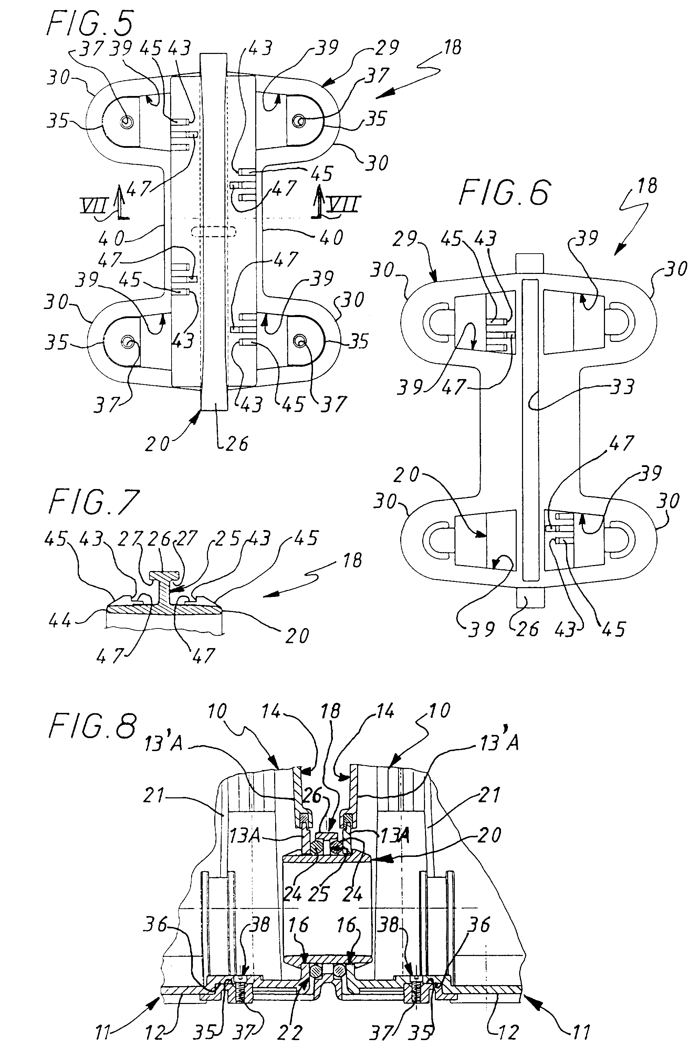

De manière connue en soi, ce dispositif de jumelage 18 comporte une paroi de pontage 20, qui, allongée en forme de tunnel, est apte à s'étendre de l'un à l'autre des deux coffrets 10, pour l'établissement d'une liaison entre les volumes internes 21 de ces coffrets 10 au niveau des parois latérales 13A verticales de leur corps 11 par lesquelles ils sont juxtaposés, figure 8.

Formant un tube, et, plus précisément, un tube globalement cylindrique, la paroi de pontage 20 a une section transversale fermée en boucle sur elle-même, en pratique suivant un contour allongé complémentaire de celui d'un ajour 16, et, ainsi qu'il est représenté sur la figure 8, cette paroi de pontage 20 est localement entourée par des moyens d'étanchéité 22 aptes à s'appliquer aux parois latérales 13A de l'un et de l'autre des coffrets 10 autour d'elle.

Dans la forme de réalisation représentée, les moyens d'étanchéité 22 comportent deux joints d'étanchéité 24, qui sont par exemple de type joint torique à section transversale circulaire, tel que représenté, mais qui, en variante, peuvent avoir une section transversale rectangulaire, et, suivant l'invention, ces deux joints d'étanchéité 24 sont adossés dos à dos à un flasque médian 25 présent en saillie transversalement sur la paroi de pontage 20, en étant chacun respectivement disposés de part et d'autre de ce flasque médian 25.

En pratique, le flasque médian 25 s'étend annulairement tout autour de la paroi de pontage 20, dans la zone médiane de celle-ci.

Dans la forme de réalisation représentée, le flasque médian 25 est lui-même ceinturé par un rebord 26, qui fait saillie sur l'une et l'autre de ses faces, en délimitant ainsi avec lui un logement 27, en forme de gorge, pour l'un et l'autre des joints d'étanchéité 24, et qui s'étend de manière globalement cylindrique, parallèlement à la paroi de pontage 20, à distance de celle-ci.

Suivant l'invention, le dispositif de jumelage 18 comporte un piétement 29, et ce piétement 29 forme, du côté de chaque extrémité de cette paroi de pontage 20, au moins une patte de liaison 30, qui, globalement allongée, suivant un plan, parallèlement à la paroi de pontage 20, à distance de celle-ci, est destinée à être insérée sous le fond 12 du coffret 10 correspondant.

Dans la forme de réalisation représentée, le piétement 29 forme, du côté de chaque extrémité de la paroi de pontage 20, deux pattes de liaison 30, qui, globalement parallèles l'une à l'autre, s'étendent à distance l'une de l'autre, perpendiculairement au flasque médian 25.

En pratique, le piétement 29 est formé, d'une part, d'un jambage 31, qui s'étend sensiblement dans le prolongement du flasque médian 25, et, d'autre part, d'une semelle 32, à laquelle appartiennent les pattes de liaison 30.

Dans la forme de réalisation représentée, le jambage 31 s'étend à compter du rebord 26 du flasque médian 25, à ras avec l'une et l'autre des tranches de ce rebord 26, et, pour son allégement, il est creusé d'une rainure 33 qui débouche sur la surface inférieure de la semelle 32.

Dans la forme de réalisation représentée, chacune des pattes de liaison 30 comporte, en saillie sur sa surface supérieure, c'est-à-dire du côté de la paroi de pontage 20, un bossage 35 destiné à s'emboîter dans un évidement 36 prévu à cet effet en creux de manière complémentaire sur le fond 12 du coffret 10 correspondant, et, plus précisément, sur le fond 12 du corps 11 de ce coffret 10.

En pratique, pour préserver l'étanchéité, les évidements 36 que comporte ainsi sur sa surface inférieure le fond 12 du corps 11 des coffrets 10 sont des évidements borgnes.

Dans la forme de réalisation représentée, le bossage 35 des pattes de liaison 30 que comporte le dispositif de jumelage 18 a, en plan, un contour en demi-lune, avec un bord droit du côté du jambage 31, parallèlement à celui-ci, et un fond en arceau du côté opposé à ce jambage 31, et il comporte, en creux sur sa surface supérieure, c'est-à-dire du côté de la paroi de pontage 20, un puits 37, pour l'intervention éventuelle d'une vis 38, tel que représenté sur la figure 8.

Ainsi qu'il est aisé de le comprendre, les bossages 35 que présente ainsi le piétement 29 du dispositif de jumelage 18 suivant l'invention constituent, à la fois, d'une part, des moyens de positionnement, qui assurent un calage positif, l'un par rapport à l'autre, des deux coffrets 10, dans toutes les directions du plan du fond 12 de leur corps 11, en assurant, donc, aussi bien tout le parallélisme souhaitable entre ces deux coffrets 10 que leur alignement, et, d'autre part, des moyens de crochetage, qui permettent déjà, par eux-mêmes, l'encliquetage, en aveugle, du dispositif de jumelage 18, sur l'un et l'autre de ces deux coffrets 10.

Les vis 38 éventuellement mises en oeuvre permettent si désiré de confirmer cet encliquetage, en maintenant les pattes de liaison 30 fermement plaquées contre les fonds 12 auxquels elles sont appliquées.

Par ce plaquage, une bonne étanchéité se trouve en outre avantageusement maintenue à leur niveau.

Dans la forme de réalisation représentée, chacune des pattes de liaison 30 du piétement 29 est par ailleurs ajourée par un évidement 39, qui s'étend, en pratique, de son bossage 35 au jambage 31.

En outre, dans cette forme de réalisation, la semelle 32 de ce piétement 29 se circonscrit aux pattes de liaison 30 et à deux traverses 40 les reliant par paires de part et d'autre du jambage 31.

Dans la forme de réalisation représentée, des moyens de crochetage 41 sont prévus, du côté de chaque extrémité de la paroi de pontage 20, sur le flanc 42 au moins de celle-ci qui, parallèle à la semelle 32 du piétement 29, est le plus éloigné de cette semelle 32, pour assurer, à ce niveau, un serrage convenable des moyens d'étanchéité 22.

Ces moyens de crochetage 41 comportent au moins un cran d'encliquetage 43, qui, en saillie, extérieurement, sur la paroi de pontage 20, s'étend en retrait par rapport à la tranche 44 de celle-ci, et est en pratique précédé d'un chanfrein d'engagement 45 du côté de cette tranche 44.

Dans la forme de réalisation représentée, deux jeux de trois crans d'encliquetage 43 sont prévus à distance l'un de l'autre le long de la tranche 44 de la paroi de pontage 20, à chaque extrémité de cette paroi de pontage 20, et, pour faciliter le moulage de l'ensemble, ces crans d'encliquetage 43 sont établis en regard d'évidements 46 affectant localement le flasque médian 25, et, d'une des extrémités à l'autre de la paroi de pontage 20, ils sont, par jeux, décalés les uns par rapport aux autres.

Dans la forme de réalisation représentée, la paroi de pontage 20 présente, localement, au droit du cran d'encliquetage 43 médian de chacun des jeux de crans d'encliquetage 43, une surépaisseur 47, qui, dans l'alignement de ce cran d'encliquetage 43 médian, s'étend en direction du flasque médian 25, à compter du pied de ce cran d'encliquetage 43 médian.

Si désiré, et comme représenté, il peut également être prévu des crans d'encliquetage 43, précédés de chanfreins d'engagement 45, sur le flanc 48 de la paroi de pontage 20 qui, lui aussi parallèle à la semelle 32 du piétement 29, s'étend du côté de cette semelle 32.

Mais, en réalité, eu égard à l'encliquetage déjà assuré de ce côté par les bossages 35 des pattes de liaison 30, ces crans d'encliquetage 43 sont superflus à cet endroit.

Enfin, dans la forme de réalisation représentée, il est prévu au moins une cloison interne 50 dans le passage que délimite la paroi de pontage 20, pour une reprise d'effort de l'un à l'autre de ses flancs 42, 48.

En pratique, dans cette forme de réalisation, seule une cloison interne 50 est prévue, à mi-longueur, dans ce passage, perpendiculairement au flasque médian 25.

On supposera tout d'abord dans ce qui suit que l'un des coffrets 10 à relier, et par exemple celui représenté en traits continus sur la figure 1, est déjà installé sur une quelconque surface de support et qu'il est aussi éventuellement déjà équipé.

La mise en place du dispositif de jumelage 18 suivant l'invention se fait alors en décollant tout d'abord légèrement de cette surface de support ce coffret 10, du côté où, tel que schématisé en traits interrompus sur la figure 1, un autre coffret 10 doit lui être juxtaposé.

Après l'élimination de l'opercule défonçable 17 de l'ajour 16 correspondant, le dispositif de jumelage 18, dûment équipé de joints d'étanchéité 24, est engagé par ses pattes de liaison 30 sous le fond 12 du corps 11 de ce coffret 10, jusqu'à s'encliqueter dans les évidements 36 de celui-ci.

Conjointement, la paroi de pontage 20 du dispositif de jumelage 18 s'engage dans son volume interne 21, à la faveur de l'ajour 16 de sa paroi latérale 13A, jusqu'à venir se crocheter sur cette paroi latérale 13A par ses crans d'encliquetage 43 correspondants.

Il suffit de mettre ensuite en place l'autre coffret 10, et, donc, en pratique, celui schématisé en traits interrompus sur la figure 1, en suivant un processus d'engagement et d'encliquetage de même type.

Lors des manipulations correspondantes, les crans d'encliquetage 43 forment, si nécessaire, pour les joints d'étanchéité 24, des butées ultimes s'opposant avantageusement à ce qu'ils échappent à la paroi de pontage 20.

Au terme de la mise en place du dispositif de jumelage 18, les joints d'étanchéité 24 constituant conjointement les moyens d'étanchéité 22 se trouvent préférentiellement légèrement comprimés axialement.

En outre, et ainsi qu'on le notera, la paroi de pontage 20 est nettement engagée dans les volumes internes 21 des coffrets 10, ses tranches 44 se trouvant largement au-delà des parois latérales 13A concernées du corps 11 de ceux-ci.

Bien entendu, la présente invention ne se limite pas à la forme de réalisation décrite et représentée, mais englobe toute variante d'exécution couverte par les revendications annexées.

## Revendications

1. Dispositif de jumelage pour coffrets disposés côte à côte, du genre comportant une paroi de pontage (20), qui, allongée en forme de tunnel, est apte à s'étendre de l'un à l'autre des coffrets (10), pour l'établissement d'une liaison entre les volumes internes (21) de ces coffrets (10) au niveau de leurs parois latérales (13A), et qui, formant un tube, a une section transversale fermée en boucle sur elle-même, avec, entourant localement cette paroi de pontage (20), des moyens d'étanchéité (22) aptes à s'appliquer aux parois latérales (13A) de l'un et de l'autre des coffrets (10), caractérisé en ce qu'il comporte un piétement (29), et en ce que ce piétement (29) forme, du côté de chaque extrémité de la paroi de pontage (20), au moins une patte de liaison (30), qui, globalement allongée parallèlement à la paroi de pontage (20), à distance de celle-ci, est destinée à être insérée sous le fond (12) du coffret (10) correspondant.

2. Dispositif de jumelage suivant la revendication 1, caractérisé en ce que la patte de liaison (30) comporte en saillie un bossage (35) destiné à s'emboîter dans un évidement (36) prévu à cet effet de manière complémentaire en creux sur le fond (12) du coffret (10) correspondant.

3. Dispositif de jumelage suivant la revendication 2, caractérisé en ce que le bossage (35) comporte un puits (37) pour l'intervention éventuelle d'une vis (38).

4. Dispositif de jumelage suivant l'une quelconque des revendications 1 à 3, caractérisé en ce que le piétement (29) forme, du côté de chaque extrémité de la paroi de pontage (20), deux pattes de liaison;(30), qui, globalement parallèles l'une à l'autre, s'étendent à distance l'une de l'autre.

5. Dispositif de jumelage suivant l'une quelconque des revendications 1 à 4, caractérisé en ce que les moyens d'étanchéité (22) comportent deux joints d'étanchéité (24) adossés dos à dos à un flasque médian (25) présent en saillie transversalement sur la paroi de pontage (20).

6. Dispositif de jumelage suivant la revendication 5, caractérisé en ce que le flasque médian (25) est ceinturé par un rebord (26) qui fait saillie sur l'une et l'autre de ses faces et délimite ainsi avec lui un logement (27) en forme de gorge pour l'un et l'autre des joints d'étanchéité (24).

7. Dispositif de jumelage suivant l'une quelconque des revendications 5, 6, caractérisé en ce que le piétement (29) est formé, d'une part, d'un jambage (31), qui s'étend sensiblement dans le prolongement du flasque médian (25), et, d'autre part, d'une semelle (32), à laquelle appartiennent les pattes de liaison (30).

8. Dispositif de jumelage suivant les revendications 6 et 7, prises conjointement, caractérisé en ce que le jambage (31) du piétement (29) s'étend à compter du rebord (26) du flasque médian (25), à ras avec l'une et l'autre des tranches de ce rebord (26).

9. Dispositif de jumelage suivant l'une quelconque des revendications 1 à 8, caractérisé en ce que, des moyens de crochetage (41) étant prévus du côté de chaque extrémité de la paroi de pontage (20), et ces moyens de crochetage (41) comportant au moins un cran d'encliquetage (43) en saillie, extérieurement, sur cette paroi de pontage (20), ce cran d'encliquetage (43) est en retrait par rapport à la tranche (44) correspondante de la paroi de pontage (20).

10. Dispositif de jumelage suivant la revendication 9, caractérisé en ce que, d'une des extrémités à l'autre de la paroi de pontage (20), les crans d'encliquetage (43) sont décalés les uns par rapport aux autres.

11. Dispositif de jumelage suivant l'une quelconque des revendications 1 à 10, caractérisé en ce qu'il est prévu au moins une cloison interne (50) dans le passage que délimite la paroi de pontage (20).

## Patentansprüche

1. Verbindungsvorrichtung für nebeneinander angeordnete Gehäuse, die eine tunnelförmige, langgestreckte Uberbrükkungswand (20) aufweist, die sich zur Herstellung einer Verbindung zwischen den Innenvolumen (21) der Gehäuse (10) auf Höhe ihrer Seitenwände (13A) vom einen der Gehäuse (10) zum anderen erstrecken kann und die ein Rohr bildet und einen ringförmig geschlossenen Querschnitt hat, wobei diese Überbrückungswand (20) örtlich von Dichtungseinrichtungen (22) umgeben ist, die sich an die Seitenwände (13A) beider Gehäuse (10) anlegen können, dadurch gekennzeichnet, daß sie einen Fuß (29) aufweist, und daß dieser Fuß (29) auf der Seite jedes Endes der Überbrückungswand (20) mindestens einen Verbindungslappen (30) bildet, der insgesamt parallel zur Uberbrückungswand (20) in einem Abstand von dieser langgestreckt ist und dazu bestimmt ist, unter den Boden (12) des entsprechenden Gehäuses (10) eingesetzt zu werden.

2. Verbindungsvorrichtung nach Anspruch 1, dadurch gekennzeichnet, daß der Verbindungslappen (30) eine vorstehende Erhebung (35) aufweist, die dazu bestimt ist, in eine Aussparung (36) einzugreifen, die zu diesem Zweck ergänzend vertieft auf dem Boden (12) des entsprechenden Gehäuses (10) vorgesehen ist.

3. Verbindungsvorrichtung nach Anspruch 2, dadurch gekennzeichnet, daß die Erhebung (35) einen Schact (37) für das eventuelle Eingreifen einer Schraube (38) aufweist.

4. Verbindungsvorrichtung nach einem der Ansprüche 1 bis 3, dadurch gekennzeichnet, daß der Fuß (29) auf der Seite jedes Endes der Überbrückungswand (20) zwei Verbindungslappen (30) bildet, die insgesamt zueinander parallel sind und sich in einem Abstand voneinander erstrecken.

5. Verbindungsvorrichtung nach einem der Ansprüche 1 bis 4, dadurch gekennzeichnet, daß die Dichtungseinrichtungen (22) zwei Dichtringe (24) umfassen, die Rücken an Rücken an eine Mittelwange (25) angelegt sind, die in Querrichtung an der Überbrückungswand (20) vorstehend vorgesehen ist.

6. Verbindungsvorrichtung nach Anspruch 5, dadurch gekennzeichnet, daß die Mittelwange (25) von einer Umrandung (26) umgeben ist, die auf ihren beiden Seiten vorsteht und auf diese Weise mit ihr eine nutförmige Aufnahme (27) für den einen und den anderen der Dichtringe (24) abgrenzt.

7. Verbindungsvorrichtung nach einem der Ansprüche 5, 6, dadurch gekennzeichnet, daß der Fuß (29) einerseits aus einem Schenkel (31), der sich im wesentlichen in der Verlängerung der Mittelwange (25) erstreckt, und andererseits aus einer Fußplatte (32) gebildet ist, zu der die Verbindungslappen (30) gehören.

8. Verbindungsvorrichtung nach den Ansprüchen 6 und 7 zusammen, dadurch gekennzeichnet, daß der Schenkel (31) des Fußes (29) sich von der Umrandung (26) der Mittelwange (25) aus erstreckt, wobei er mit den beiden Kanten dieser Umrandung (26) bündig ist.

9. Verbindungsvorrichtung nach einem der Ansprüche 1 bis 8, dadurch gekennzeichnet, daß auf der Seite jedes Endes der Überbrückungswand (20) Einhakmittel (41) vorgesehen sind, die mindestens eine Rasterung (43) aufweisen, die außen an dieser Überbrückungswand (20) vorsteht, und daß diese Rasterung (43) bezüglich der entsprechenden Kante (44) der Überbrückungswand (20) zurückversetzt ist.

10. Verbindungsvorrichtung nach Anspruch 9, dadurch gekennzeichnet, daß die Rasterungen (43) von einem der Enden der Überbrückungswand (20) zum anderen gegeneinander versetzt sind.

11. Verbindungsvorrichtung nach einem der Ansprüche 1 bis 10, dadurch gekennzeichnet, daß in dem Durchgang, den die Uberbrückungswand (20) abgrenzt, mindestens eine Innenwand (50) vorgesehen ist.

## Claims

1. A coupling device for boxes disposed side-by-side, of the kind comprising a bridging wall (20) which, being elongate in a tunnel shape, is capable of extending from one of the boxes (10) to the other to establish a communication between the internal volumes (21) of said boxes (10) at the location of their side walls (13A) and which, forming a tube, is of a cross-section that is closed on to itself in a loop configuration, with, locally surrounding said bridging wall (20), sealing means (22) which are capable of being applied to the side walls (13A) of one and other of the boxes (10), characterised in that it comprises a leg arrangement (29) and that said leg arrangement (20), at each end of the bridging wall (20), forms at least one connecting lug (30) which, being generally elongate in parallel relationship to the bridging wall (20), at a spacing therefrom, is intended to be fitted under the bottom (12) of the corresponding box (10).

2. A coupling device according to claim 1 characterised in that the connecting lug (30) comprises in projecting relationship a boss portion (35) intended to engage into a recess (36) complementarily provided for that purpose in recessed relationship in the bottom (12) of the corresponding box (10).

3. A coupling device according to claim 2 characterised in that the boss portion (35) comprises an opening (37) for the possible engagement of a screw (38).

4. A coupling device according to any one of claims 1 to 3 characterised in that at each end of the bridging wall (20) the leg arrangement (29) forms two connecting lugs (30) which, being generally parallel to each other, extend at a spacing from each other.

5. A coupling device according to any one of claims 1 to 4 characterised in that the sealing means (22) comprise two seals (24) disposed in back-to-back relationship with a central flange (25) disposed in projecting relationship transversely on the bridging wall (20).

6. A coupling device according to claim 5 characterised in that the central flange (25) is surrounded by a rim portion (26) which projects from both of its faces and which thus defines therewith a housing (27) in the form of a groove for each of the seals (24).

7. A coupling device according to either one of claims 5 and 6 characterised in that the leg arrangement (29) is formed on the one hand by a leg portion (31) which extends substantially in line with the central flange (35) and on the other hand a base portion (32) to which the connecting lugs (30) belong.

8. A coupling device according to claims 6 and 7 in combination characterised in that the leg portion (31) of the leg arrangement (29) extends from the rim portion (26) of the central flange (25) level with respective ones of the end faces of said rim portion (26).

9. A coupling device according to any one of claims 1 to 8 characterised in that, fastening means (41) being provided at each end of the bridging wall (20) and said fastening means (41) comprising at least one latching catch (43) in projecting relationship externally on said bridging wall (20), said latching catch (43) is set back with respect to the corresponding end face (44) of the bridging wall (20).

10. A coupling device according to claim 9 characterised in that, from one of the ends to the other of the bridging wall (20), the latching catches (43) are displaced with respect to each other.

11. A coupling device according to any one of claims 1 to 10 characterised in that there is provided at least one internal partition (50) in the passage defined by the bridging wall (20).
